# EUROPÄISCHE PATENTANMELDUNG

(11) **EP 3 621 148 A2**
(43) Veröffentlichungstag der Anmeldung: **11.03.2020**
(21) Anmeldenummer: 19195934.5
(22) Anmeldetag: 06.09.2019
(51) Int. Cl.: H01P 5/16, H03F 3/195, H03F 3/24, H03F 3/60

(54) **LEISTUNGSVERSTÄRKER FÜR DEN HOCHFREQUENZBEREICH**

(30) Priorität: 07.09.2018 DE 102018121918
(71) Anmelder: Deutsches Elektronen-Synchrotron DESY, 22607 Hamburg (DE)
(72) Erfinder: Ebert, Michael, 22607 Hamburg (DE)
(74) Vertreter: Prinz & Partner mbB

(57) **Zusammenfassung**

Eine Vorrichtung zum Verstärken eines Hochfrequenzsignals umfasst mindestens eine erste Verstärkereinheit und eine Summierleitung. Die Summierleitung kann insbesondere ein Summierhohlleiter sein. Die erste Verstärkereinheit umfasst ein Verstärkerelement. Das Verstärkerelement kann insbesondere ein Transistor sein. Die erste Verstärkereinheit umfasst ferner einen ausgangsseitigen Richtkoppler, ein ausgangsseitiges Abschlusselement und einen ausgangsseitigen Leitungsabschnitt. Der ausgangsseitige Leitungsabschnitt ist zwischen einen Ausgang des Verstärkerelements und das ausgangsseitige Abschlusselement gekoppelt. Die erste Verstärkereinheit ist so ausgebildet, dass eine Leitungsimpedanz des ausgangsseitigen Leitungsabschnittes an eine Ausgangsimpedanz des Ausgangs des Verstärkerelements angepasst ist. Die erste Verstärkereinheit ist so ausgebildet, dass ein Richtkoppler eine erste Seite an dem ausgangsseitigen Leitungsabschnitt und eine zweite Seite an der Summierleitung aufweist. Der Richtkoppler koppelt das Hochfrequenzsignal in die Summierleitung ein.

## Beschreibung

### GEBIET DER ERFINDUNG

Die Erfindung betrifft eine Vorrichtung zur Verstärkung eines elektromagnetischen Signals, insbesondere die Leistungsverstärkung eines Hochfrequenzsignals.

### HINTERGRUND

Im Hochfrequenzbereich werden unterschiedliche Verstärkertypen, wie Klystrons, Klystroden (engl. inductive output tube IOT) und Hochleistungsverstärker auf Halbleiterbasis (solid state power amplifier, SSPA) eingesetzt, um hohe Ausgangsleistungen im Bereich von einigen zehn bis einigen hundert Kilowatt zu erreichen. Hochleistungsverstärker auf Halbleiterbasis (SSPA) zeichnen sich durch eine hohe Modularität, hohe Zuverlässigkeit, einfache Wartbarkeit und hohe Reparierfreundlichkeit gegenüber röhrenbasierten Verstärkertypen aus. Bezüglich Konversionseffizienz und Herstellungskosten haben die Hochleistungsverstärker auf Halbleiterbasis (SSPA) in den letzten Jahren das Niveau von röhrenbasierten Verstärkertypen erreicht.

Konventionell aufgebaute Hochleistungsverstärker auf Halbleiterbasis (SSPA) setzen sich aus zahlreichen parallel geschalteten Verstärkermodulen bzw. Verstärkereinheiten (solid state amplifier, SSA) zusammen. Die Leistungstransistoren in den einzelnen Verstärkereinheiten (SSA) können aufgrund ihrer Kristallgröße und der dadurch begrenzten Wärmeableitung nur Ausgangsleistungen im Bereich von wenigen hundert Watt abgeben.

Eine Verstärkereinheit beinhaltet einen oder mehrere Leistungshalbleiter, beispielsweise Feldeffekttransistoren, die das Hochfrequenzsignal verstärken. Ein- und Ausgangsimpedanz von Hochfrequenz-Leistungstransistoren weichen stark von der Impedanz der speisenden und leistungsabführenden Bauelemente ab. Kabel, Buchsen, Koppler, Abschlusswiderstände weisen überwiegend eine Impedanz von 50 Ohm auf. In der Verstärkereinheit werden Ein- und Ausgangsimpedanz der Transistoren über Transformatoren an die Systemimpedanz von 50 Ohm angepasst. Des Weiteren umfasst die elektrische Schaltung der Verstärkereinheit (SSA) Gleichspannungsversorgungen zur Einstellung des Arbeitspunktes und zur Lieferung des Arbeitsstroms des Transistors. Zusätzliche Bauelemente in der elektrischen Schaltung der Verstärkereinheit (SSA), wie beispielsweise Spulen, Kondensatoren und Leitungselemente wirken als Hochfrequenz-Sperre und Gleichspannungs-Trennglieder, um den Hochfrequenz-Stromkreis und den Gleichstromkreis voneinander zu trennen.

Um die hohen Ausgangsleistungen im Kilowattbereich der Hochleistungsverstärker (SSPA) zu erzielen, werden die Ausgangsleistungen der einzelnen Verstärkereinheiten (SSA) aufsummiert. Hierfür werden die Ausgänge der Verstärkereinheiten (SSA) über ein Netzwerk von Richtkopplern verbunden.

In moderneren Hochleistungsverstärkern (SSPA) erfolgt die Summierung der Ausgangsleistungen der einzelnen Verstärkereinheiten (SSA) über sogenannte Power-Combiner. Bei einem solchen Power-Combiner werden die Ausgänge von N Verstärkereinheiten (SSA) parallel geschaltet. Die resultierende niedrige Quellimpedanz von beispielsweise 50/N Ohm wird dann wieder über einen Transformator auf die Systemimpedanz von 50 Ohm transformiert. Zur Erzielung hoher Leistungen können die Schritte der Leistungssummierung mehrfach wiederholt werden.

In einer bekannten Form von Hochleistungsverstärkern (SSPA) werden Hohlraumresonatoren in Form von zylindrischen Kavitäten zur Leistungssummierung der einzelnen Verstärkereinheiten (SSA) verwendet. Hierfür wird das Design des Hohlraumresonators so ausgelegt, dass sich ein axial symmetrisches uniformes elektromagnetisches Feld ausbilden kann. Die Ausgangsleistung der einzelnen Verstärkereinheiten (SSA) wird über zahlreiche Antennen auf der Mantelfläche resonant in den Hohlraumresonator eingekoppelt. In einem letzten Schritt wird das resultierende Hochfrequenzsignal von der Kavität über eine Koppelantenne an einer Stirnfläche in einen Hohlleiter eingekoppelt.

Eine andere bekannte Form von Hochleistungsverstärkern (SSPA) verwendet, anstatt einer zylindrischen Kavität, einen einseitig kurzgeschlossenen und ausgangseitig mit einer Irisblende versehenen Rechteck-Hohlleiter als Hohlraumresonator zur Leistungssummierung der einzelnen Verstärkereinheiten (SSA).

Die bisherigen Hochleistungsverstärker auf Halbleiterbasis (SSPA) weisen unterschiedliche Nachteile im Hinblick auf die Leistungssummierung der einzelnen Ausgangsleistungen der Verstärkereinheiten (SSA) auf. Sowohl in konventionell aufgebauten als auch in moderneren Hochleistungsverstärkern auf Halbleiterbasis (SSPA) ist zur Summierung der Ausgangsleistungen eine umfangreiche Verkabelung zur Verbindung der Verstärkereinheiten (SSA) mit den Kopplern oder Power-Combinern notwendig.

Die Leistungssummierung in Hochleistungsverstärkern auf Halbleiterbasis (SSPA) mit Hohlraumresonatoren hat den Nachteil, dass die Anzahl der Antennen durch die Geometrie des Hohlraumresonators begrenzt ist und nicht beliebig modular erweitert werden kann.

### ZUSAMMENFASSUNG DER ERFINDUNG

Es ist eine Aufgabe der Erfindung, die bekannten Nachteile von Hochleistungsverstärker auf Halbleiterbasis (SSPA) des Standes der Technik auszuräumen, oder zumindest zu verringern.

Gemäß einem Aspekt umfasst die Vorrichtung zum Verstärken eines Hochfrequenzsignals mindestens eine erste Verstärkereinheit und eine Summierleitung. Die Summierleitung kann insbesondere ein Summierhohlleiter sein. Die erste Verstärkereinheit umfasst ein Verstärkerelement. Das Verstärkerelement kann insbesondere ein Transistor sein. Die erste Verstärkereinheit umfasst ferner einen ausgangsseitigen Richtkoppler, ein ausgangsseitiges Abschlusselement und einen ausgangsseitigen Leitungsabschnitt. Der ausgangsseitige Leitungsabschnitt ist zwischen einem Ausgang des Verstärkerelements und dem ausgangsseitigen Abschlusselement gekoppelt. Die erste Verstärkereinheit ist so ausgebildet, dass eine Leitungsimpedanz des ausgangsseitigen Leitungsabschnittes an eine Ausgangsimpedanz des Ausgangs des Verstärkerelements angepasst ist. Die erste Verstärkereinheit ist so ausgebildet, dass ein Richtkoppler eine erste Seite an dem ausgangsseitigen Leitungsabschnitt und eine zweite Seite an der Summierleitung aufweist. Der Richtkoppler koppelt das Hochfrequenzsignal in die Summierleitung ein.

Die Vorrichtung kann so ausgebildet sein, dass die erste Verstärkereinheit bzw. der ausgangsseitige Richtkoppler ein Antennenpaar mit einer ersten und einer zweiten Antenne umfasst. Das Einkoppeln in die Summierleitung, insbesondere in den Summierhohlleiter, kann somit über die erste und zweite Antenne erfolgen.

Der ausgangsseitige Richtkoppler bzw. die ausgangsseitigen Richtkoppler der Verstärkereinheiten können vorteilhaft einen Teil des ausgangsseitigen Leitungsabschnittes und das Antennenpaar mit der ersten und zweiten Antenne umfassen, das mit dem Teil des ausgangsseitigen Leitungsabschnittes elektrisch gekoppelt ist, wobei das Einkoppeln in die Summierleitung über das Antennenpaar erfolgt.

Der Teil des ausgangsseitigen Leitungsabschnittes kann vorteilhaft eine Länge haben, die einem ungeradzahligen Vielfachen eines Viertels der Wellenlänge des Hochfrequenzsignals im ausgangsseitigen Leitungsabschnitt entspricht. Dieses ungeradzahlige Vielfache kann vorteilhaft größer Eins sein.

Die erste und zweite Antenne sind vorteilhaft um ein Viertel oder ein ungerades ganzzahliges Vielfaches eines Viertels der Wellenlänge des Hochfrequenzsignals in der Summierleitung zueinander beabstandet angeordnet. Die so ausgebildete Vorrichtung gewährleistet, dass sich das eingekoppelte Hochfrequenzsignal in der Summierleitung (bspw. Summierhohlleiter) nur in eine Wellenrichtung entlang der Summierleitung ausbreitet.

In einer weiteren Ausführungsform kann die Vorrichtung ein erstes und ein zweites Loch in der Summierleitung, insbesondere in dem Summierhohlleiter, im Bereich des ausgangsseitigen Leitungsabschnittes aufweisen. Dadurch ist ein Einkoppeln des Hochfrequenzsignals von dem ausgangsseitigen Leitungsabschnitt in die Summierleitung über das erste und zweite Loch möglich.

Der Abstand zwischen einem Mittelpunkt des ersten und einem Mittelpunkt des zweiten Lochs kann in vorteilhafter Weise einem Viertel oder einem ungeraden ganzzahligen Vielfachen eines Viertels der Wellenlänge des Hochfrequenzsignals in der Summierleitung entsprechen. Dies ermöglicht, dass sich das eingekoppelte Hochfrequenzsignal in der Summierleitung (bspw. Summierhohlleiter) wie in der Ausführungsform mit dem Antennenpaar nur in eine Wellenrichtung entlang der Summierleitung ausbreiten kann.

In einer weiteren Ausführungsform kann die Vorrichtung einen Schlitz in der Summierleitung aufweisen, der entlang des ausgangsseitigen Leitungsabschnittes verläuft. Die Länge des Schlitzes kann einem Viertel oder einem ungeraden ganzzahligen Vielfachen eines Viertels der Wellenlänge des Hochfrequenzsignals in der Summierleitung entsprechen.

Die zuvor beschriebenen beiden Löcher oder der Schlitz können demnach als Bestandteile des ausgangsseitigen Richtkopplers in Form einer alternativen Ausgestaltung für die erste und zweite Antenne angesehen werden.

Die Vorrichtung kann so ausgebildet sein, dass die Verstärkereinheit und/oder das Verstärkerelement auf der Summierleitung angeordnet ist. Die so ausgebildete Vorrichtung hat dadurch eine besonders kompakte Bauweise und ermöglicht die Kühlung der Transistoren durch die als Kühlkörper wirkende Summierleitung.

Die Vorrichtung kann so ausgebildet sein, dass das Abschlusselement aus einem HF-absorbierenden Substrat ausgebildet ist oder ein HF-absorbierendes Substrat umfasst. Dies ermöglicht, insbesondere wenn das HF-absorbierende Substrat eine genügend niedrige elektrische Leitfähigkeit aufweist, dass zusätzliche Bauelemente, wie beispielsweise Spulen und Kondensatoren, in der elektrischen Schaltung der Verstärkereinheit eingespart werden können.

Das bedeutet, dass das Abschlusselement auch ein elektrisch nichtleitendes Substrat umfassen kann.

Da das Abschlusselement ein HF-absorbierendes Substrat umfassen kann, bedeutet das auch, dass das Abschlusselement ein Einkoppeln eines Hochfrequenzsignals aus dem jeweiligen Leitungsabschnitt in die jeweilige Versorgungsspannung der Verstärkereinheit verhindern kann. Folglich kann das Abschlusselement derart ausgebildet sein, dass keine zusätzlichen Filterelemente nötig sind, um eine Trennung von Gleichstrom- und Hochfrequenzsignalen an den Hochfrequenzeingängen bzw. Hochfrequenzausgängen zu gewährleisten.

Die erste Verstärkereinheit kann einen eingangsseitigen Leitungsabschnitt umfassen. Der eingangsseitige Leitungsabschnitt kann an einem Eingang des Verstärkerelements eine Leitungsimpedanz aufweisen, die an eine Eingangsimpedanz des Eingangs des Verstärkerelements angepasst ist.

Das bedeutet, dass die Spannungsversorgung des Verstärkerelements mittels des eingangsseitigen bzw. ausgangsseitigen Leitungsabschnitts gewährleistet werden kann.

Die erste Verstärkereinheit kann einen eingangsseitigen Richtkoppler umfassen. Der eingangsseitige Richtkoppler kann mit dem eingangsseitigen Leitungsabschnitt gekoppelt sein, um ein hochfrequentes Eingangssignal in den eingangsseitigen Leitungsabschnitt einzuspeisen. Dies ermöglicht in vorteilhafter Weise, dass ein Hochfrequenzsignal aus einer Treiberleitung durch einen Richtkoppler mit gleichzeitiger Impedanzanpassung ausgekoppelt und in den eingangsseitigen Leitungsabschnitt eingekoppelt werden kann.

Die erste Verstärkereinheit kann eingangsseitig bezüglich einer Phase und einer Amplitude einstellbar sein. Dies ermöglicht, dass die Phase und die Amplitude des Hochfrequenzsignals vorteilhaft an die benötigte Phasen- und Amplitudeneinstellung im Transistor angepasst werden kann.

Eine Mehrzahl von Verstärkereinheiten, die ähnlich wie die erste Verstärkereinheit aufgebaut sind, kann entlang der Summierleitung nacheinander (kaskadiert) angeordnet sein. Dies ermöglicht in vorteilhafter Weise, dass das Hochfrequenzsignal in der Summierleitung nach der ersten Verstärkereinheit durch die nachfolgend angeordneten Verstärkereinheiten weiter verstärkt wird.

Insofern kann die Vorrichtung also mindestens eine weitere, zweite Verstärkereinheit aufweisen. Die zweite Verstärkereinheit kann dann ebenfalls ein Verstärkerelement, insbesondere einen Transistor, einen ausgangsseitigen Richtkoppler, ein ausgangsseitiges Abschlusselement, und einen ausgangsseitigen Leitungsabschnitt umfassen, der zwischen einen Ausgang des Verstärkerelements und das ausgangsseitige Abschlusselement gekoppelt ist. Eine Leitungsimpedanz des ausgangsseitigen Leitungsabschnittes kann an eine Ausgangsimpedanz des Ausgangs des Verstärkerelements angepasst sein. Der ausgangsseitige Richtkoppler kann mit einer ersten Seite an den ausgangsseitigen Leitungsabschnitt und einer zweiten Seite an die Summierleitung zum Einkoppeln eines Hochfrequenzsignals in die Summierleitung gekoppelt sein. Der ausgangsseitige Richtkoppler der zweiten Verstärkereinheit kann sich vorteilhaft zumindest in einem Koppelfaktor bzw. einer Koppeldämpfung von dem ausgangsseitigen Richtkoppler der ersten Verstärkereinheit unterscheiden.

Die erste Verstärkereinheit und die zweite Verstärkereinheit können entlang der Summierleitung in Wellenausbreitungsrichtung des Hochfrequenzsignals in der Summierleitung nacheinander (kaskadiert) angeordnet sein.

Der Koppelfaktor bzw. die Koppeldämpfung des ausgangsseitigen Richtkopplers der zweiten Verstärkereinheit kann so eingerichtet sein, dass er die Verstärkung des Hochfrequenzsignals durch vorhergehende (entgegen der Wellenausbreitungsrichtung in der Summierleitung) Verstärkereinheiten vorteilhaft nutzt.

Die Koppeldämpfung der ausgangsseitigen Richtkoppler ausgehend von der ersten Verstärkereinheit zur zweiten Verstärkereinheit kann vorteilhaft zunehmen. Dies ermöglicht eine destruktive Überlagerung der Hochfrequenzsignale im ausgangsseitigen Leitungsabschnitt der zweiten Verstärkereinheit, wodurch im Abschlusselement der zweiten Verstärkereinheit keine oder zumindest weniger Leistung in Wärme umgesetzt wird.

Im vorliegenden Kontext bedeutet ein Zunehmen der Koppeldämpfung, dass diese entlang der Summierleitung in Wellenausbreitungsrichtung betragsmäßig zunimmt bzw. größer wird, bzw. dass der Koppelfaktor kleiner wird.

Gemäß einem weiteren vorteilhaften Aspekt kann die Vorrichtung so ausgebildet sein, dass die Verstärkerelemente der Kaskade von Verstärkereinheiten im Wesentlichen gleich aufgebaut sind und/oder eine im Wesentlichen gleiche Ausgangsleistung bzw. Verstärkung liefern.

Dann kann die Koppeldämpfung des ausgangsseitigen Richtkopplers einer vorausgehenden (bzgl. der Wellenausbreitungsrichtung in der Summierleitung) ersten Verstärkereinheit 3 dB betragen und die Koppeldämpfung der unmittelbar nachfolgenden zweiten Verstärkereinheit 4,8 dB betragen. Dies gewährleistet in vorteilhafter Weise, dass entlang der Summierleitung, hier als Summierhohlleiter, immer die gleiche Ausgangsleistung vom Verstärkerelement in die Summierleitung eingekoppelt wird und sich die aufsummierte Leistung in der Summierleitung um diesen Wert erhöht. Ferner wird hierdurch auch die zuvor erwähnte destruktive Interferenz bezüglich des Abschlusselements erreicht.

Die Impedanzanpassung im ausgangsseitigen Richtkoppler der ersten Verstärkereinheit, der zweiten Verstärkereinheit und folgender Verstärkereinheiten kann über eine Geometrie des Richtkopplers erfolgen. Dies ermöglicht, dass über die Bauform des Richtkopplers die Impedanztransformation zwischen dem ausgangsseitigen Leitungsabschnitt und der Summierleitung in vorteilhafter einfacher Weise erreicht wird.

Die Anpassung der Koppeldämpfung kann über die Ausgestaltung der Antennen, der Löcher oder des Schlitzes des Richtkopplers erfolgen.

Allgemein können sich also die Verstärkereinheiten der Kaskade durch die Art des ausgangsseitigen Richtkopplers unterscheiden.

Die so ausgebildete Vorrichtung ermöglicht es in vorteilhafter Weise, dass die Ausgangsleistungen der Verstärkereinheiten in der Summierleitung mit gleichzeitiger Impedanztransformation durch den Richtkoppler aufsummiert werden. Umfangreiche Verkabelung und Impedanztransformationsnetzwerke entfallen dadurch.

Die kaskadierte Anordnung der Verstärkereinheiten ermöglicht einen modularen Aufbau der Vorrichtung, da beliebig viele weitere Verstärkereinheiten entlang der Summierleitung angeordnet werden können.

Gemäß einem weiteren vorteilhaften Aspekt kann die Vorrichtung so ausgebildet sein, dass zwischen den Verstärkerelementen, beziehungsweise den Verstärkereinheiten, und der Summierleitung eine Wasserkühlung vorgesehen ist.

Die Wasserkühlung kann sich entlang der gesamten Breite der Summierleitung erstrecken.

Die Wasserkühlung kann abschnittsweise oder entlang der gesamten Länge der Summierleitung angebracht sein, um eine effektive Kühlung der Transistoren zu ermöglichen.

Insbesondere im Falle eines Summierhohlleiters kann die Summierleitung einen im Wesentlichen rechteckigen Querschnitt aufweisen. Der rechteckige Querschnitt gewährleistet, dass sich ein Hochfrequenzsignal optimal durch die Summierleitung ausbreiten kann. Die Höhe der Summierleitung kann dann geringer sein als die Hälfte der Breite der Summierleitung. Dies ermöglicht eine platzsparende Bauweise der Vorrichtung.

Die Vorrichtung kann für einen Frequenzbereich des Hochfrequenzsignals von ca. 300 MHz bis ca. 3 GHz ausgelegt sein. Dies gewährleistet in vorteilhafter Weise, dass das Verstärkerprinzip über einen weiten Frequenzbereich für unterschiedliche Anwendungen angewendet werden kann.

Die Vorrichtung kann für einen gepulsten Betrieb und/oder einen Dauerstrich-Betrieb ausgelegt sein.

### KURZE BESCHREIBUNG DER FIGUREN

Weitere vorteilhafte Aspekte und Merkmale der Erfindung werden anhand der nachfolgenden Beschreibung von Ausführungsbeispielen unter Bezugnahme auf die beigefügten Figuren verdeutlicht, dabei ist
FIG. 1 ein vereinfachtes schematisches Schaltbild einer Verstärkereinheit in einer Vorrichtung gemäß einem Ausführungsbeispiel,
FIG. 2 eine vereinfachte schematische Darstellung von nacheinander angeordneten Verstärkereinheiten entlang einer Summierleitung in Wellenausbreitungsrichtung zur Leistungssummierung gemäß einem Ausführungsbeispiel,
FIG. 3 ein vereinfachter schematischer Ausschnitt eines Hochleistungsverstärkers in einer Ausführungsform mit einer auf einer Summierleitung angeordneten Verstärkereinheit,
FIG. 4 eine vereinfachte Darstellung entlang eines Querschnitts A-A des Hochleistungsverstärkers gemäß FIG. 3, und
FIG. 5 eine vereinfachte Darstellung entlang eines Querschnitts B-B von auf einer Summierleitung angeordneten Verstärkereinheiten mit einer ersten und zweiten Antenne.

### AUSFÜHRLICHE BESCHREIBUNG DER AUSFÜHRUNGSBEISPIELE

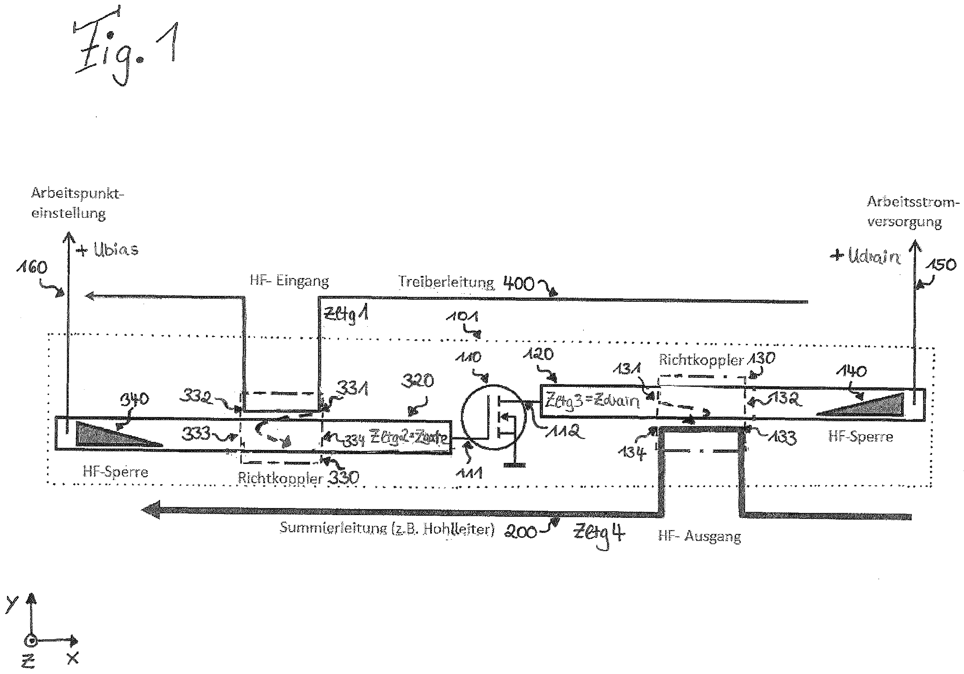

FIG. 1 zeigt ein vereinfachtes schematisches Schaltbild einer ersten Verstärkereinheit 101 in einer Vorrichtung 10, insbesondere in einem Hochleistungsverstärker auf Halbleiterbasis (SSPA), mit einer Summierleitung 200 in Form eines Hohlleiters zur Leistungssummierung der einzelnen Verstärkereinheiten.

Die Vorrichtung 10 kann zur Verstärkung eines Hochfrequenzsignals in einem Frequenzbereich von ca. 300 MHz bis ca. 3 GHz ausgelegt sein. Die Vorrichtung 10 kann für einen gepulsten Betrieb als auch für einen Dauerstrich-Betrieb ausgelegt sein.

Die erste Verstärkereinheit 101 ist so ausgebildet, dass sie mindestens ein Verstärkerelement 110, einen ausgangsseitigen Richtkoppler 130, ein ausgangsseitiges Abschlusselement 140 und einen ausgangsseitigen Leitungsabschnitt 120 umfasst. Die erste Verstärkereinheit 101 ist durch eine gepunktete Linie eingerahmt.

Die erste Verstärkereinheit 101 erstreckt sich in einer ersten Richtung X, in einer zweiten Richtung Y, die zur ersten Richtung senkrecht orientiert ist, und in einer dritten Richtung Z, die zu der ersten und zweiten Richtung senkrecht orientiert ist. Die erste, zweite und dritte Richtung X, Y, Z bilden die Achsen eines kartesischen Koordinatensystems.

An der Ausgangsseite des Verstärkerelements 110 schließt sich der ausgangsseitige Leitungsabschnitt 120, beispielsweise eine Streifenleitung, an. Der ausgangsseitige Leitungsabschnitt 120 bildet in einem Abschnitt eine erste Seite des ausgangseitigen Richtkopplers 130. Ein Abschnitt der Summierleitung 200 bildet eine zweite Seite des ausgangsseitigen Richtkopplers 130. Der ausgangsseitige Richtkoppler 130 ist mit einer gestrichelten Linie eingerahmt. Der ausgangsseitige Leitungsabschnitt 120 endet mit dem ausgangsseitigen Abschlusselement 140, beispielsweise einem Wellensumpf. Der ausgangsseitige Leitungsabschnitt 120 ist somit zwischen dem Ausgang des Verstärkerelements 110 und das ausgangsseitige Abschlusselement 140 gekoppelt. Das ausgangsseitige Abschlusselement 140 ist aus einem HF-absorbierenden Substrat ausgebildet bzw. umfasst dieses Substrat.

Das Verstärkerelement 110 kann vorteilhafterweise ein Transistor, insbesondere ein Feldeffekttransistor, sein. Gemäß einer ersten Ausführungsform schließt sich an der Eingangsseite bzw. am Gate 111 des Feldeffekttransistors 110 ein eingangsseitiger Leitungsabschnitt 320 an. Der eingangsseitige Leitungsabschnitt 320 bildet in einem Abschnitt eine erste Seite eines eingangsseitigen Richtkopplers 330. Ein Abschnitt einer Treiberleitung 400 bildet eine zweite Seite des eingangsseitigen Richtkopplers 330. Der eingangsseitige Leitungsabschnitt 320 endet mit einem eingangsseitigen Abschlusselement 340, beispielsweise einen Wellensumpf. Das eingangsseitige Abschlusselement 340 ist aus einem HF- absorbierenden Substrat ausgebildet bzw. umfasst dieses Substrat.

Das Verstärkerelement 110 ist an zwei Spannungsversorgungen gekoppelt. An der Eingangsseite bzw. am Gate 111 des Feldeffekttransistors 110 liegt eine erste Spannung Ubias über dem eingangsseitigen Leitungsabschnitt 320 an. Die erste Spannung Ubias stellt den Arbeitspunkt des Feldeffekttransistors 110 ein. Am Drain-Anschluss 112 des Feldeffekttransistors 110 liegt über dem ausgangsseitigen Leitungsabschnitt 120 eine zweite Spannung Udrain an. Die zweite Spannung Udrain stellt die Arbeitsstromversorgung des Feldeffekttransistors 110 dar.

Das bedeutet, dass das Verstärkerelement 110 von einem eingangsseitigen Leitungsabschnitt 320 und einem ausgangsseitigen Leitungsabschnitt 120 eingerahmt ist. Dabei umfassen sowohl der eingangsseitige Leitungsabschnitt 320 als auch der ausgangsseitige Leitungsabschnitt 320 am vom Verstärkerelement 110 abgewandten Ende ein jeweiliges Abschlusselement 140, 340. Da das jeweilige Abschlusselement 140, 340 ein HF-absorbierendes Substrat umfasst, ermöglichen der eingangsseitige Leitungsabschnitt 320 und der ausgangsseitige Leitungsabschnitt 120 die Zuführung der ersten Spannung Ubias zur Einstellung des Arbeitspunkts des Verstärkerelements 110 und der zweiten Spannung Udrain zur Arbeitsstromversorgung des Verstärkerelements 110. Insbesondere wird dies gewährleistet, wenn das jeweilige Abschlusselement 140, 340 ein elektrisch nichtleitendes Substrat aufweist. In anderen Worten wird die Zuführung der ersten und zweiten Spannung zum Verstärkerelement 110 ohne zusätzliche Komponenten nur mittels des eingangsseitigen und ausgangsseitigen Leitungsabschnitts 120, 320 gewährleistet. Gleichzeitig verhindern die jeweiligen Abschlusselemente 140, 40 ein Einkoppeln eines Hochfrequenzsignals aus dem jeweiligen Leitungsabschnitt 120, 320 in die jeweilige Versorgungsspannung des Verstärkerelements 110. Folglich sind keine zusätzlichen Filterelemente nötig, um eine Trennung von Gleichstromsignalen und Hochfrequenzeingängen 331, 332 und Hochfrequenzausgängen 133, 134 zu gewährleisten.

Ein Hochfrequenzsignal breitet sich in einer Treiberleitung 400 entgegengesetzt zur X-Richtung aus und durchläuft die erste Seite des eingangsseitigen Richtkopplers 330. Dabei koppelt ein Teil des Hochfrequenzsignals auf die zweite Seite. Somit wird am eingangsseitigen Richtkoppler 330 das Hochfrequenzsignal von der Treiberleitung 400 in den eingangsseitigen Leitungsabschnitt 320 eingekoppelt.

Die erste und zweite Seite des Richtkopplers weisen jeweils zwei Tore auf. Der eingangsseitige Richtkoppler 330 weist somit ein erstes Tor 331, ein zweites Tor 332, ein drittes Tor 333 und ein viertes Tor 334 auf. Die erste Seite des eingangsseitigen Richtkopplers 330 hat ein Eingangstor 331 zum Empfangen des Hochfrequenzsignals von der Treiberleitung 400 und ein Durchgangstor 332. Die erste Seite bildet den Durchgangspfad des Richtkopplers. Die zweite Seite des eingangsseitigen Richtkopplers 330 hat ein Auskopplungstor 334, an dem das ausgekoppelte Hochfrequenzsignal austritt, und ein weiteres Tor 333. Die zweite Seite bildet den Koppelpfad des Richtkopplers. Der eingangsseitige Richtkoppler 330 ist ein Rückwärtskoppler. Der eingangsseitige Richtkoppler 330 gibt idealerweise kein Hochfrequenzsignal am dritten Tor 333 aus. Der eingangsseitige Richtkoppler 330 kann in einer weiteren Ausführungsform auch ein Vorwärtskoppler sein.

Ein Koppelfaktor oder die Koppeldämpfung geben das Verhältnis an, von der am Auskopplungstor 334 ausgekoppelten Leistung zur Leistung am Eingangstor 331. Der Koppelfaktor kann beispielsweise für ein Hochfrequenzsignal über die Geometrie des Richtkopplers eingestellt werden. Der eingangsseitige Richtkoppler 330 ist so ausgebildet, dass nicht nur eine Leistungskopplung erfolgt, sondern auch eine Impedanzanpassung. Die Leitungsimpedanz bzw. der Leitungswellenwiderstand Zltg1 am Eingangstor 331 des Durchgangspfades hat typischerweise einen Wert von 50 Ω. Die Leitungsimpedanz Zltg2 am Auskopplungstor 334 im eingangsseitigen Leitungsabschnitt 320 entspricht in vorteilhafter Weise der Eingangsimpedanz Zgate am Eingang des Feldeffekttransistors 110. Der Koppelfaktor des eingangsseitigen Richtkopplers 330 ist vorteilhafterweise so eingestellt, dass exakt so viel Leistung von der Treiberleitung 400 in den eingangsseitigen Leitungsabschnitt 320 gekoppelt wird, dass der Feldeffekttransistor 110 ausgangsseitig seine Nennleistung abgibt.

Das am Auskopplungstor 334 in den eingangsseitigen Leitungsabschnitt 320 gekoppelte Hochfrequenzsignal breitet sich in X-Richtung zum Eingang des Feldeffekttransistors 110 aus. Im Falle einer Impedanzfehlanpassung zwischen Durchgangstor 332 und einer sich anschließenden Last in der Treiberleitung 400, erscheint ein reflektiertes Hochfrequenzsignal am dritten Tor 333 im eingangsseitigen Leitungsabschnitt 320. Das reflektierte Hochfrequenzsignal breitet sich in Richtung des eingangsseitigen Abschlusselements 340 aus und wird von diesem absorbiert. Der Reflexionsgrad des eingangsseitigen Abschlusselements 340 ist in vorteilhafter Weise nahezu Null.

Im Feldeffekttransistor 110 kann das Hochfrequenzsignal auf mehrere hundert Watt verstärkt werden. Ausgehend vom Drain-Anschluss 112 des Feldeffekttransistors 110 breitet sich das Hochfrequenzsignal in X-Richtung aus und durchläuft den Durchgangspfad des ausgangsseitigen Richtkopplers 130. In Folge dessen wird ein Hochfrequenzsignal in den Auskoppelpfad des ausgangsseitigen Richtkopplers 130 gekoppelt und breitet sich entgegengesetzt zur X-Richtung in der Summierleitung 200 aus.

Der ausgangsseitige Richtkoppler 130 weist ebenfalls ein erstes Tor 131, ein zweites Tor 132, ein drittes Tor 133 und ein viertes Tor 334 auf, wobei das erste Tor das Eingangstor 131, das zweite Tor das Durchgangstor 132 und das vierte Tor das Auskopplungstor 134 ist. Der ausgangsseitige Richtkoppler 130 ist ebenfalls ein Rückwärtskoppler. Der ausgangsseitige Richtkoppler 130 kann in einer weiteren Ausführungsform ebenfalls ein Vorwärtskoppler sein. Der ausgangsseitige Richtkoppler 130 ist so ausgebildet, dass nicht nur eine Leistungskopplung erfolgt, sondern auch eine Impedanzanpassung. Die Leitungsimpedanz Zltg3 am Eingangstor 131 des ausgangsseitigen Richtkopplers 130 im ausgangsseitigen Leitungsabschnitt 120 entspricht in vorteilhafter Weise der Ausgangsimpedanz Zdrain am Ausgang des Feldeffekttransistors 110, um eine Leistungsanpassung am Ausgang des Feldeffekttransistors 110 zu erreichen. Die Leitungsimpedanz Zltg4 am Auskopplungstor 134 in der Summierleitung 200 hat im Falle einer Hohlleiterleitung typischerweise einen Wert von mehreren Hundert Ohm

Die Koppeldämpfung des ausgangsseitigen Richtkopplers 130 ist vorteilhafterweise so eingestellt, dass möglichst viel Leistung von dem ausgangsseitigen Leitungsabschnitt 120 in die Summierleitung 200 gekoppelt wird. Wird nicht die gesamte Leistung am Eingangstor 131 von dem ausgangsseitigen Leitungsabschnitt 120 in die Summierleitung 200 gekoppelt, tritt ein Hochfrequenzsignal am Durchgangstor 132 aus. Der ausgangsseitige Richtkoppler 130 koppelt zudem auch ein Hochfrequenzsignal aus der Summierleitung 200 in den ausgangsseitigen Leitungsabschnitt 120. In diesem Fall ist das dritte Tor 133 ein Eingangstor und empfängt das Hochfrequenzsignal. Das Hochfrequenzsignal kann am Durchgangstor 132, das in diesem Fall das Auskopplungstor ist, ausgekoppelt werden. Das gekoppelte Hochfrequenzsignal überlagert sich in vorteilhafter Weise im ausgangsseitigen Leitungsabschnitt 120 mit dem Hochfrequenzsignal vom Feldeffekttransistor 110. Die beiden Hochfrequenzsignale sind vorteilhafterweise so ausgebildet, dass sie eine Phasendifferenz von 180° und gleich große Amplituden aufweisen, so dass eine destruktive Interferenz auftritt. Liegt keine optimale Phasendifferenz von 180° vor oder sind die Amplituden unterschiedlich, kann sich ein Hochfrequenzsignal in Richtung des ausgangsseitigen Abschlusselements 140 ausbreiten. Das ausgangsseitige Abschlusselement 140 ist aus einem HF-absorbierenden Substrat ausgebildet und absorbiert das abgeschwächte Hochfrequenzsignal bzw. wandelt die Energie in Wärme um.

Gemäß einer weiteren Ausführungsform kann die Eingangsseite des Feldeffekttransistors 110 auf konventionelle Art mittels eines Transformationsnetzwerkes, bestehend aus Streifenleitungselementen mit unterschiedlichen Leitungswellenwiderständen und Längen realisiert werden. Die Ausgangsimpedanz einer Signalquelle von typisch 50 Ohm kann so an die Eingangsimpedanz Zgate des Feldeffekttransistors 110 angepasst werden.

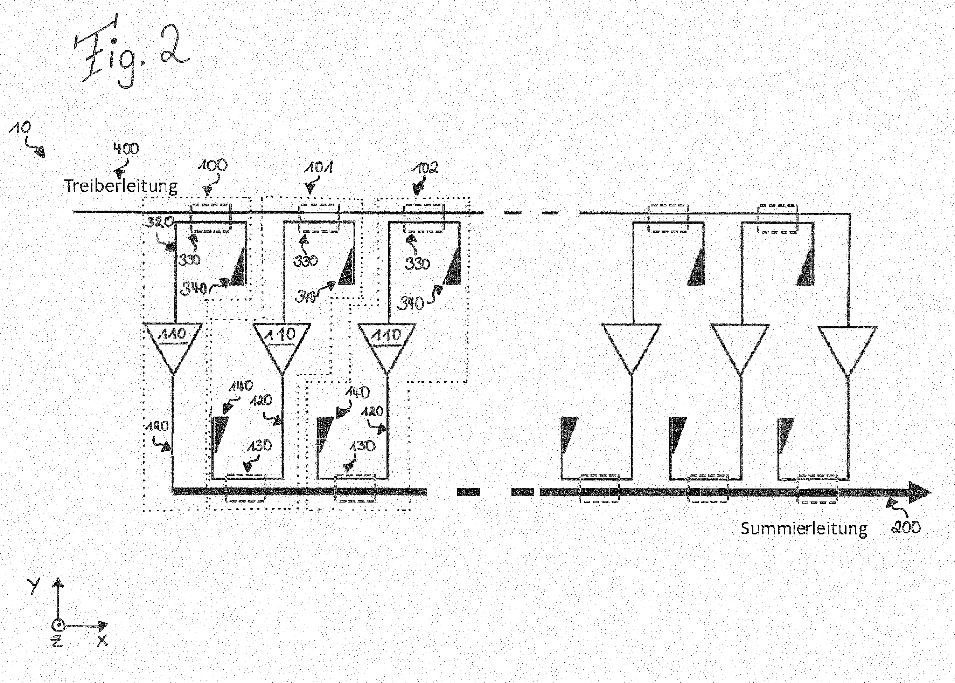

FIG. 2 zeigt eine vereinfachte schematische Darstellung eines Ausführungsbeispiels von nacheinander (kaskadiert) angeordneten Verstärkereinheiten entlang einer Summierleitung 200 in Wellenausbreitungsrichtung zur Leistungssummierung in einer Vorrichtung 10, bspw. einem Hochleistungsverstärker auf Halbleiterbasis (SSPA).

Ein Hochfrequenzsignal breitet sich in der Treiberleitung 400 in X-Richtung aus. In einer Eingangsverstärkereinheit 100 wird an einem eingangsseitigen Richtkoppler 330 das Hochfrequenzsignal von der Treiberleitung 400 in den eingangsseitigen Leitungsabschnitt 320 eingekoppelt. Die Eingangsverstärkereinheit 100 umfasst ein Verstärkerelement 110 und einen ausgangsseitigen Leitungsabschnitt 120. Das Hochfrequenzsignal wird im Verstärkerelement 110 verstärkt und am Ende des ausgangsseitigen Leitungsabschnitt 120 über einen geeigneten Hohlleiterübergang, beispielsweise mittels einer Antenne, direkt in die Summierleitung 200, hier als Summierhohlleiter, eingespeist. Das verstärkte Hochfrequenzsignal breitet sich in der Summierleitung 200 in X-Richtung aus. Durch eine erste Verstärkereinheit 101 wird das eingekoppelte Hochfrequenzsignal in der Summierleitung 200 weiter verstärkt. Hierfür wird das Hochfrequenzsignal des ausgangsseitigen Richtkopplers 130 der ersten Verstärkereinheit 101 phasenmäßig so eingestellt, dass es mit dem Hochfrequenzsignal in der Summierleitung 200 konstruktiv interferiert. Durch die Einkopplung des Hochfrequenzsignals von der ersten Verstärkereinheit 101 in die Summierleitung 200 wird die Amplitude des Hochfrequenzsignals in der Summierleitung 200 erhöht.

Eine zweite Verstärkereinheit 102 wird hinter der ersten Verstärkereinheit 101 in Wellenausbreitungsrichtung an der Summierleitung 200 (*cascade-connected coupler*) angeordnet, um das Hochfrequenzsignal in der Summierleitung 200 bzw. hier in dem Summierhohlleiter erneut zu verstärken. Jede Verstärkereinheit 101, 102 koppelt im Wesentlichen die gleiche Leistung des Verstärkerelements 110 (1 VL) in die Summierleitung 200 ein. Die Verstärkerelemente 110 der Verstärkereinheiten 101, 102 sind daher vorzugsweise die gleichen bzw. vom gleichen Typ, d.h. sie liefern dieselbe Ausgangsleistung. An der ersten Verstärkereinheit 101 wird eine zusätzliche Verstärkerleistung (1 VL) zu der Verstärkerleistung (1 VL) in der Summierleitung 200 hinzugefügt. Die Koppeldämpfung entspricht in diesem Fall 3 dB. An der zweiten Verstärkereinheit 102 wird eine weitere Verstärkerleistung (1 VL) zu den Verstärkerleistungen (2 VL) in der Summierleitung 200 hinzugefügt. Die Koppeldämpfung entspricht in diesem Fall 4,8 dB. Die Koppeldämpfung der ausgangsseitigen Richtkoppler 130 der Verstärkereinheiten 101, 102 nimmt somit entlang der Summierleitung 200 in Wellenausbreitungsrichtung zu. Die Koppeldämpfung kann etwa in den Schritten 3 dB, 4,8 dB, 6 dB, 7 dB, 7,8 dB usw. zunehmen. Der ausgangsseitige Richtkoppler 130 koppelt somit in den einzelnen Verstärkereinheiten 101, 102 ein Halb, ein Drittel, ein Viertel, ein Fünftel, ein Sechstel usw. der Gesamtleistung in der Summierleitung 200 hinzu.

Im vorliegenden Kontext bedeutet ein Zunehmen der Koppeldämpfung, dass diese entlang der Summierleitung 200 in Wellenausbreitungsrichtung betragsmäßig zunimmt bzw. größer wird, bzw. dass der Koppelfaktor kleiner wird.

Mit zunehmender Anzahl an Verstärkereinheiten wird die Änderung der Koppeldämpfung geringer. Vereinfachend könnte die Koppeldämpfung bei entsprechend kleiner Änderung auch über einen Teil der Verstärkereinheiten konstant gehalten werden.

Die Impedanzanpassung der einzelnen ausgangsseitigen Richtkoppler 130 auf mehrere hundert Ohm in der Summierleitung 200, hier als Summierhohlleiter, erfolgt über deren Geometrie.

Die Treiberleitung 400 endet am Eingang des Verstärkerelements 110 einer Ausgangsverstärkereinheit. Die Eingangsseite der Ausgangsverstärkereinheit weist keinen Richtkoppler auf.

Gemäß einer weiteren Ausführungsform kann die Summierleitung 200 statt eines geradlinigen Verlaufs auch einen mäanderförmigen Verlauf aufweisen. Dies ermöglicht eine besonders kompakte Bauform des Hochleistungsverstärkers auf Halbleiterbasis (SSPA) 10.

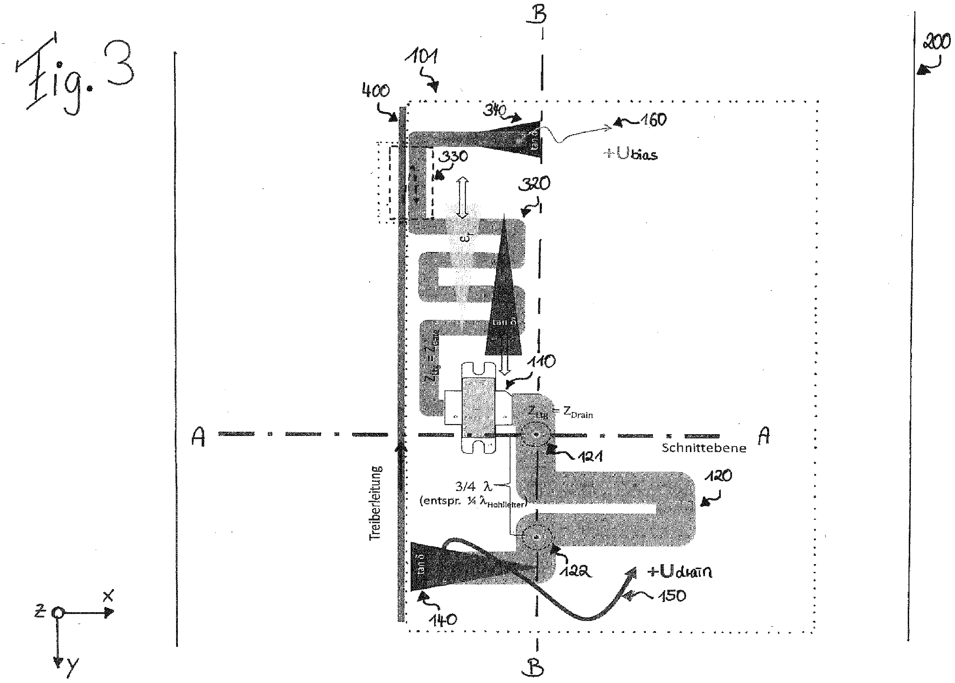

FIG. 3 zeigt einen vereinfachten schematischen Ausschnitt eines Hochleistungsverstärkers auf Halbleiterbasis (SSPA) 10 in einer Ausführungsform mit einer auf einer Summierleitung 200 angeordneten ersten Verstärkereinheit 101.

Die erste Verstärkereinheit 101 ist unmittelbar an der entgegen der Y-Richtung verlaufenden Treiberleitung 400 angeordnet. Das Hochfrequenzsignal wird über den eingangsseitigen Richtkoppler 330 von der Treiberleitung 400 in den eingangsseitigen Leitungsabschnitt 320 eingekoppelt. Das eingekoppelte Hochfrequenzsignal breitet sich entlang des eingangsseitigen Leitungsabschnittes 320 in Richtung des Verstärkerelementes 110 aus. Das austretende Hochfrequenzsignal aus dem dritten Tor 333 des eingangsseitigen Richtkopplers 330 wird in dem Abschlusselement 340, dargestellt als Dreieck, durch einen hohen dielektrischen oder magnetischen Verlustfaktor tan δ in Verlustwärme umgewandelt.

Während der Ausbreitung in Richtung des Verstärkerelementes 110 erfolgt im mäanderförmigen Verlauf des eingangsseitigen Leitungsabschnittes 320 eine Amplituden- und Phasenjustierung des eingekoppelten Hochfrequenzsignals. Die Amplituden- und Phasenjustierung erfolgt durch das auf den eingangsseitigen Leitungsabschnitt 320 positionierte und als Dreieck dargestellte Substrat. Das mit εr gekennzeichnete Substratdreieck verfügt über eine hohe Permittivität und bewirkt eine Verlangsamung der Wellenausbreitung, die zu einer Phasenänderung des Hochfrequenzsignals führt. Die Phaseneinstellung des Hochfrequenzsignals erfolgt angepasst an die benötigte Phaseneinstellung im Feldeffekttransistor 110.

Das mit tan δ gekennzeichnete Substratdreieck verfügt über einen hohen magnetischen Verlustfaktor und bewirkt eine Dämpfung der Wellenamplitude des Hochfrequenzsignals. Die Amplitudeneinstellung des Hochfrequenzsignals erfolgt angepasst an die benötigte Verstärkung des Feldeffekttransistors 110.

Das Hochfrequenzsignal wird im Verstärkerelement 110 der ersten Verstärkereinheit 101 verstärkt. Vom Ausgang des Verstärkerelementes 110 breitet sich das verstärke Hochfrequenzsignal entlang des ausgangsseitigen Leitungsabschnittes 120 aus. Der ausgangsseitige Richtkoppler 130 kann ein Hohlleiterkoppler sein. Der ausgangsseitige Leitungsabschnitt 120 weist hierfür ein elektrisch verbundenes Antennenpaar mit einer ersten und zweiten Antenne 121, 122 auf. Der Abstand der beiden Antennen 121, 122 entspricht in vorteilhafterweise λ/4, wobei λ die Wellenlänge des Hochfrequenzsignals in der Summierleitung 200 ist. Die Wellenlänge in der Summierleitung 200, hier als Summierhohlleiter, unterscheidet sich von der Wellenlänge im ausgangsseitigen Leitungsabschnitt 120. Die Wellenlänge im ausgangsseitigen Leitungsabschnitt 120 ist kürzer als in der Summierleitung 200. Aufgrund der kürzeren Wellenlänge im Leitungsabschnitt 120 kann der Abstand von λ/4 der Wellenlänge in der Summierleitung 200 auf dem Leitungsabschnitt nicht implementiert werden. Stattdessen wird eine Wegstrecke im ausgangsseitigen Leitungsabschnitt 120 (d.h. ein Teil des ausgangsseitigen Leitungsabschnittes) von ¾ λ verwendet (ungeradzahliges Vielfaches (> 1) von λ/4) deren Wirkung der einer λ/4 langen Wegstrecke entspricht. Durch die Antennen 121, 122 wird das Hochfrequenzsignal vom Durchgangspfad in den Kopplungspfad des ausgangseitigen Richtkopplers 130 gekoppelt. Die Hochfrequenzwelle kann sich im Kopplungspfad in zwei entgegengesetzte Richtungen ausbreiten. Einmal ausgehend vom dritten Tor 133 zum Auskopplungstor 134 in Y-Richtung und ausgehend vom Auskopplungstor 134 zum dritten Tor 133 entgegen der Y-Richtung. Der ausgangsseitige Richtkoppler 130 ist dann in dieser Ausführungsform ein Vorwärtskoppler. Durch den Abstand der beiden Antennen von λ/4 wird erreicht, dass sich die Hochfrequenzwellen in Y-Richtung vorteilhaft überlagern und im Wesentlichen keine Phasendifferenz aufweisen. Im Gegensatz dazu weisen die Hochfrequenzwellen entgegen der Y-Richtung eine Phasendifferenz von 180° auf, wodurch eine destruktive Interferenz entsteht. Die Wellenausbreitungsrichtung der Hochfrequenzwellen in der Summierleitung 200 entspricht somit der Y-Richtung.

Die Impedanzanpassung im ausgangsseitigen Leitungsabschnitt 120 an die Leitungsimpedanz der Summierleitung 200 erfolgt in den einzelnen ausgangsseitigen Richtkopplern 130 über die Geometrie (Form etc.) der Antennen 121, 122.

In einer weiteren Ausführungsform kann der ausgangsseitige Richtkoppler 130 ein erstes und ein zweites Loch in der Summierleitung 200 anstatt der Antennen 121, 122 aufweisen, insbesondere, wenn die Summierleitung ein Summierhohlleiter ist. Das erste und zweite Loch kann sich unmittelbar in Z-Richtung an den ausgangsseitigen Leitungsabschnitt 120 anschließen. Der Mittelpunkt des ersten und zweiten Lochs kann in der Mitte der Breite des ausgangseitigen Leitungsabschnittes 120 positioniert sein. Der Abstand zwischen den Mittelpunkten des ersten und zweiten Lochs in Y-Richtung kann einem Viertel oder einem ungeraden ganzzahligen Vielfachen eines Viertels der Wellenlänge des Hochfrequenzsignals in der Summierleitung 200 entsprechen. Der Durchmesser des ersten und zweiten Lochs kann gleich oder kleiner als die Breite des ausgangseitigen Leitungsabschnittes 120 sein. Über das erste und zweite Loch wird das Hochfrequenzsignal von dem ausgangsseitigen Leitungsabschnitt in die Summierleitung gekoppelt. Es handelt sich hier um eine Lochkopplung.

In einer weiteren Ausführungsform kann der ausgangsseitige Richtkoppler 130 einen Schlitz in der Summierleitung 200 aufweisen, der entlang des ausgangsseitigen Leitungsabschnittes 120 verläuft. Die Breite des Schlitzes kann im Wesentlichen der Breite des ausgangseitigen Leitungsabschnittes 120 entsprechen oder kleiner sein. Die Länge des Schlitzes kann einem Viertel oder einem ungeraden ganzzahligen Vielfachen eines Viertels der Wellenlänge des Hochfrequenzsignals in der Summierleitung 200 entsprechen. Das Hochfrequenzsignal wird durch den Schlitz vom ausgangsseitigen Leitungsabschnitt 120 in die Summierleitung 200 gekoppelt. Es handelt sich hier um eine Schlitzkopplung.

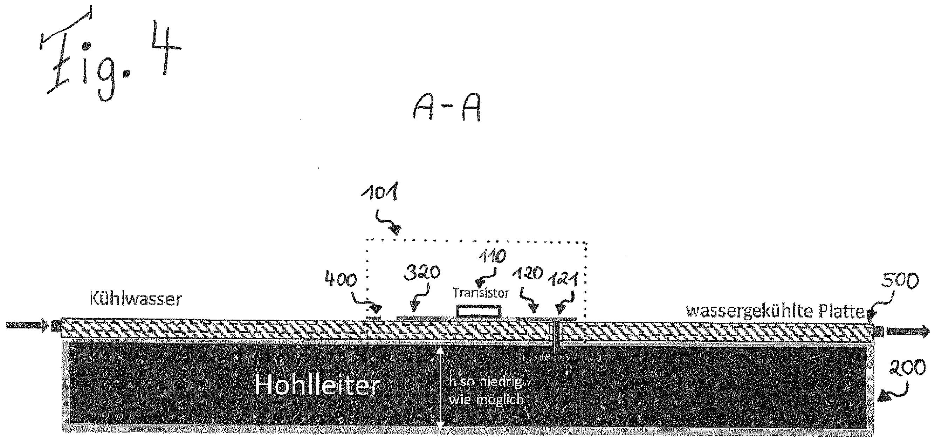

FIG. 4 zeigt eine vereinfachte Darstellung eines Querschnitts A-A des Hochleistungsverstärkers auf Halbleiterbasis (SSPA) 10 mit einer auf einer Summierleitung 200 angeordneten Verstärkereinheit 101. Das Verstärkerelement 110 in Form eines Transistors kann auf einer wassergekühlten Platte 500 mit durchlaufendem Kühlwasser angeordnet sein. Die wassergekühlte Platte 500 kann unmittelbar auf einer Summierleitung 200, hier als Summierhohlleiter mit rechteckigem Querschnitt, aufgebracht sein. Die wassergekühlte Platte 500 kann sich unter der gesamten ersten Verstärkereinheit 101 erstrecken. Die wassergekühlte Platte 500 kann sich zudem über die gesamte Breite der Summierleitung erstrecken und das Kühlwasser kann senkrecht zur Wellenausbreitungsrichtung in der Summierleitung 200 strömen. Die Wasserkühlung kann abschnittsweise entlang der Länge der Summierleitung 200 unter den Verstärkereinheiten 101,102 angebracht sein. Die Wasserkühlung kann auch entlang der gesamten Länge der Summierleitung 200 verlaufen. Über die Koppelantennen 121, 122 kann das verstärke Hochfrequenzsignal vom ausgangsseitigen Leitungsabschnitt 120 in die Summierleitung 200, hier als Summierhohlleiter, gekoppelt werden. Die Summierleitung 200 ist vorteilhaft so ausgebildet, dass die Höhe der Summierleitung 200 geringer ist als die Hälfte der Breite der Summierleitung 200. Dies ermöglicht eine besonders kompakte Bauweise.

In einer weiteren Ausführungsform können die Transistoren 110 auch unmittelbar auf der Summierleitung 200 angebracht sein und die Summierleitung 200 fungiert als alleiniges Kühlelement.

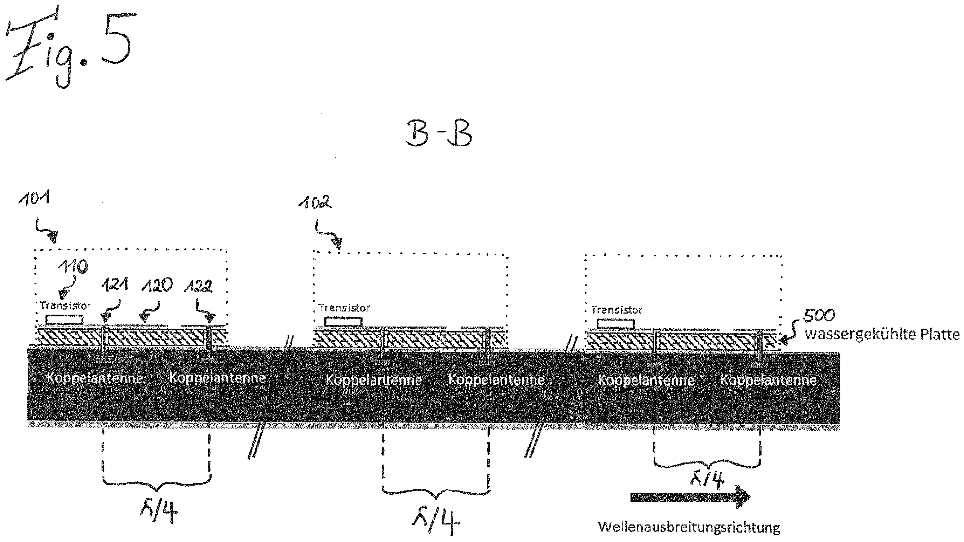

FIG. 5 zeigt eine vereinfachte Darstellung eines Querschnitts B-B von auf einer Summierleitung 200 angeordneten Verstärkereinheiten 101, 102 mit jeweiligen ausgangsseitigen Richtkopplern 130 mit jeweils einer ersten und zweiten Antenne 121, 122. Die Verstärkereinheiten 101, 102 sind in einer Kaskade hintereinander in Wellenausbreitungsrichtung des Hochfrequenzsignals in der Summierleitung angeordnet.

Das verstärkte Hochfrequenzsignal in den Verstärkereinheiten 101, 102 wird durch die jeweiligen beiden Antennen 121, 122 im ausgangseitigen Richtkoppler 130 vom ausgangsseitigen Leitungsabschnitt 120 in die Summierleitung 200 gekoppelt. Durch den Abstand der beiden Antennen von λ/4 der Wellenlänge in der Summierleitung 200, hier als Summierhohlleiter, wird erreicht, dass die eingekoppelten Hochfrequenzsignale sich in der Summierleitung 200 nur in eine Wellenausbreitungsrichtung ausbreiten und das bereits in der Summierleitung 200 befindliche Hochfrequenzsignal verstärken.

## Patentansprüche

1. Vorrichtung (10) zum Verstärken eines Hochfrequenzsignals umfassend:
mindestens eine erste Verstärkereinheit (101) und eine Summierleitung (200), insbesondere einen Summierhohlleiter, wobei die erste Verstärkereinheit (101) umfasst:
ein Verstärkerelement (110), insbesondere einen Transistor,
einen ausgangsseitigen Richtkoppler (130),
ein ausgangsseitiges Abschlusselement (140), und
einen ausgangsseitigen Leitungsabschnitt (120), der zwischen einen Ausgang des Verstärkerelements (110) und das ausgangsseitige Abschlusselement (140) gekoppelt ist, wobei eine Leitungsimpedanz (Zltg3) des ausgangsseitigen Leitungsabschnittes (120) an eine Ausgangsimpedanz (Zdrain) des Ausgangs des Verstärkerelements (110) angepasst ist, und
der ausgangsseitige Richtkoppler (130) mit einer ersten Seite an dem ausgangsseitigen Leitungsabschnitt (120) und einer zweiten Seite an der Summierleitung (200) zum Einkoppeln des Hochfrequenzsignals in die Summierleitung (200) gekoppelt ist.

2. Vorrichtung (10) gemäß Anspruch 1, wobei der ausgangsseitige Richtkoppler (130) einen Teil des ausgangsseitigen Leitungsabschnittes (120) und ein Antennenpaar mit einer ersten und einer zweiten Antenne (121, 122) oder ein erstes und ein zweites Loch oder einen Schlitz umfasst, , wobei das Einkoppeln in die Summierleitung (200) über die erste und zweite Antenne (121, 122) oder das erste und zweite Loch oder den Schlitz erfolgt.

3. Vorrichtung (10) gemäß Anspruch 1 oder 2, wobei die Verstärkereinheit (101) und/oder das Verstärkerelement (110) auf der Summierleitung (200) angeordnet ist.

4. Vorrichtung (10) gemäß einem der vorstehenden Ansprüche, wobei das Abschlusselement (140) ein HF-absorbierendes Substrat umfasst.

5. Vorrichtung (10) gemäß einem der vorstehenden Ansprüche, wobei die erste Verstärkereinheit (101) einen eingangsseitigen Leitungsabschnitt (320) umfasst, der an einem Eingang des Verstärkerelements (110) eine Leitungsimpedanz (Zltg2) aufweist, die an eine Eingangsimpedanz (Zgate) des Eingangs des Verstärkerelements (110) angepasst ist.

6. Vorrichtung (10) gemäß Anspruch 5, wobei die erste Verstärkereinheit (101) einen eingangsseitigen Richtkoppler (330) umfasst, der mit dem eingangsseitigen Leitungsabschnitt (320) gekoppelt ist, um ein hochfrequentes Eingangssignal in den eingangsseitigen Leitungsabschnitt (320) einzuspeisen.

7. Vorrichtung (10) gemäß einem der vorstehenden Ansprüche, wobei die erste Verstärkereinheit (101) eingangsseitig bezüglich einer Phase und einer Amplitude einstellbar ist.

8. Vorrichtung (10) gemäß einem der vorstehenden Ansprüche, wobei die Vorrichtung (10) eine zweite Verstärkereinheit (102) aufweist, wobei die zweite Verstärkereinheit (102) umfasst:
ein Verstärkerelement (110), insbesondere einen Transistor,
einen ausgangsseitigen Richtkoppler (130),
ein ausgangsseitiges Abschlusselement (140), und
einen ausgangsseitigen Leitungsabschnitt (120), der zwischen einen Ausgang des Verstärkerelements (110) und das ausgangsseitige Abschlusselement (140) gekoppelt ist, wobei eine Leitungsimpedanz (Zltg3) des ausgangsseitigen Leitungsabschnittes (120) an eine Ausgangsimpedanz (Zdrain) des Ausgangs des Verstärkerelements (110) angepasst ist, und
der ausgangsseitige Richtkoppler (130) mit einer ersten Seite an dem ausgangsseitigen Leitungsabschnitt (120) und einer zweiten Seite an der Summierleitung (200) zum Einkoppeln eines Hochfrequenzsignals in die Summierleitung (200) gekoppelt ist, wobei sich zumindest eine Koppeldämpfung des ausgangsseitigen Richtkopplers (130) der zweiten Verstärkereinheit von einer Koppeldämpfung des ausgangsseitigen Richtkopplers der ersten Verstärkereinheit unterscheidet.

9. Vorrichtung (10) gemäß Anspruch 8, wobei die erste Verstärkereinheit (101) und die zweite Verstärkereinheit (102) entlang der Summierleitung (200) in Wellenausbreitungsrichtung des Hochfrequenzsignals in der Summierleitung nacheinander angeordnet sind.

10. Vorrichtung (10) gemäß Anspruch 9, wobei die Koppeldämpfung der ausgangsseitigen Richtkoppler (130) ausgehend von der ersten Verstärkereinheit (101) zur zweiten Verstärkereinheit (102) betragsmäßig zunimmt.

11. Vorrichtung (10) gemäß Anspruch 10, wobei die Impedanzanpassung im ausgangsseitigen Richtkoppler (130) der ersten Verstärkereinheit (101) und der zweiten Verstärkereinheit (102) über eine Geometrie des Richtkopplers (130) erfolgt.

12. Vorrichtung (10) gemäß einem der vorstehenden Ansprüche, wobei zwischen der ersten Verstärkereinheit (101) und/oder der zweiten Verstärkereinheit (102) und der Summierleitung (200) eine Wasserkühlung (500) vorgesehen ist.

13. Vorrichtung (10) gemäß einem der vorstehenden Ansprüche, wobei die Summierleitung (200) einen im Wesentlichen rechteckigen Querschnitt aufweist.

14. Vorrichtung (10) gemäß Anspruch 13, wobei eine Höhe der Summierleitung (200) geringer ist als die Hälfte einer Breite der Summierleitung (200).

15. Vorrichtung (10) gemäß einem der vorstehenden Ansprüche, wobei die Vorrichtung (10) für einen Frequenzbereich des Hochfrequenzsignals von 300 MHz bis 3 GHz ausgelegt ist.

16. Vorrichtung (10) gemäß einem der vorstehenden Ansprüche, wobei die Vorrichtung (10) für einen gepulsten Betrieb und/oder einen Dauerstrich-Betrieb ausgelegt ist.
